Europäisches Patentamt

European Patent Office

Office européen des brevets

(19)

(11) Numéro de publication: **0 472 137 A1**

## (12) DEMANDE DE BREVET EUROPEEN

(21) Numéro de dépôt: **91113849.3**

(22) Date de dépôt: **19.08.91**

(51) Int. Cl.5: **H03K 23/66**

(30) Priorité: **24.08.90 FR 9010616**

(43) Date de publication de la demande:
**26.02.92 Bulletin 92/09**

(84) Etats contractants désignés:
**AT BE CH DE DK ES FR GB GR IT LI LU NL SE**

(71) Demandeur: **ALCATEL RADIOTELEPHONE**
**10, rue de la Baume**
**F-75008 Paris(FR)**

(72) Inventeur: **Dartois, Luc**
**98, avenue Paul Denis Huet**
**F-78955 Carrières sous Poissy(FR)**
Inventeur: **Reusens, Peter**
**Waramde 121**
**B-9270 Laarne(BE)**
Inventeur: **Vanzieleghen, Etienne**
**c/o Alcatel Bell Telephone, Francis**
**Wellesplein 1**
**B-2018 Anvers(BE)**

(74) Mandataire: **Weinmiller, Jürgen et al**
**Lennéstrasse 9 Postfach 24**
**W-8133 Feldafing(DE)**

(54) **Horloge à division de fréquence fractionnaire et asservissement de cette horloge.**

(57) Horloge à division de fréquence fractionnaire comprenant un circuit de division (2) qui produit un signal d'horloge (Ck) à partir d'un signal de rythme (R), les fréquences de ces deux signaux étant dans un rapport de division (Q) qui est la somme d'une partie entière et d'une partie fractionnaire (F), un absorbeur d'impulsions (1) recevant ledit signal de rythme et le transmettant audit circuit de division (2) en supprimant une impulsion au moins de ce signal sur commande, et des moyens d'accumulation (3) pour commander ledit absorbeur d'impulsions (1) à chaque fois que le produit du nombre d'impulsions dudit signal d'horloge (Ck) comptées à partir d'un instant d'origine et de ladite partie fractionnaire change d'unité.

Application notamment au domaine des systèmes de télécommunication.

FIG.1

La présente invention concerne une horloge à division de fréquence fractionnaire et des moyens d'asservissement de cette horloge sur un signal de synchronisation.

La plupart des circuits électroniques sont maintenant prévus pour fonctionner avec un signal d'horloge de fréquence déterminée produit par un oscillateur. Lorsqu'un équipement comprend des circuits prévus pour fonctionner avec des signaux d'horloge différents, une première solution consiste à le pourvoir d'oscillateurs en nombre égal à celui des signaux d'horloge. Cette solution n'est manifestement pas économique. On a souvent recours, lorsque la fréquence d'un premier de ces signaux, n'est pas un multiple de celle d'un deuxième de ces signaux, à une horloge à division de fréquence fractionnaire. Une telle horloge, lorsqu'elle est réalisée entièrement en technologie numérique, produit un signal dont la fréquence moyenne sur une période de récurrence est la fréquence du signal qu'elle reçoit divisée par un rapport de division.

Il est ainsi connu d'utiliser un compteur programmable recevant un signal de rythme et prévu pour délivrer périodiquement selon la période de récurrence une première et une deuxième séries successives d'impulsions, les fréquences de répétition de ces deux séries étant des sous-multiples de la fréquence du signal de rythme. Un tel dispositif, outre le compteur programmable, nécessite deux compteurs supplémentaires pour déterminer le nombre d'impulsions de chaque série et des moyens de commande. Il occupe donc, dans le cas d'une réalisation sous forme intégrée, une surface de substrat relativement importante, ce qui est un obstacle à la miniaturisation de l'équipement dans lequel il est implanté.

Il a par ailleurs été prévu, dans la demande de brevet EP 0 019 412, d'utiliser un compteur précédé d'un absorbeur d'impulsions pour remplir la fonction d'un compteur programmable. En effet, l'absorbeur d'impulsions supprime sur commande des impulsions du signal de rythme, ce qui modifie la fréquence du signal de sortie du compteur.

Cependant, le déphasage entre le signal de sortie et un signal dont la fréquence est exactement dans le rapport de division de celle du signal de rythme est largement variable et peut présenter une forte amplitude.

Un premier objet de la présente invention est la réalisation d'une horloge à division de fréquence fractionnaire présentant une taille réduite grâce à l'emploi de circuits élémentaires plus simples et dont le signal de sortie présente un déphasage limité avec la fréquence souhaitée. Ce déphasage, dans un mode de réalisation privilégié, est inférieur à une période du signal de rythme.

Dans certains domaines d'application, notamment dans les équipements de réception de systèmes de télécommunication, il est nécessaire d'asservir le signal de sortie de cette horloge sur un signal de synchronisation.

La présente invention a donc également pour objet des moyens d'asservissement spécialement adaptés à ce type d'horloge à division de fréquence fractionnaire.

Bien qu'il ne faille pas voir là une limitation de l'invention, celle-ci sera employée de manière avantageuse dans le cadre du système européen numérique cellulaire de radiocommunication. Un terminal mobile de ce système comprend en effet un organe de codage et décodage de la parole qui peut être réalisé au moyen d'un composant standard fonctionnant avec des signaux d'horloge de 8 kHz et de 2048 kHz. Le terminal comprend de plus une horloge interne produisant un signal de rythme à 13 MHz et élabore un signal de synchronisation à 50 hz sur lequel il faut synchroniser l'organe de codage et décodage. L'invention permet ainsi, à partir du signal de rythme, de produire les signaux d'horloge synchronisés sur le signal de synchronisation.

L'horloge à division de fréquence fractionnaire selon l'invention comprend un circuit de division qui produit un signal d'horloge à partir d'un signal de rythme, les fréquences de ces deux signaux étant dans un rapport de division qui est la somme d'une partie entière et d'une partie fractionnaire, un absorbeur d'impulsions recevant le signal de rythme et le transmettant au circuit de division en supprimant une impulsion au moins de ce signal sur commande, et se caractérise en ce qu'elle comprend des moyens d'accumulation pour commander l'absorbeur d'impulsions à chaque fois que le produit du nombre d'impulsions du signal d'horloge comptées à partir d'un instant d'origine et de ladite partie fractionnaire change d'unité.

Le déphasage entre le signal d'horloge et le signal de rythme est ainsi minimisé.

De plus, dans l'horloge à division de fréquence fractionnaire, le rapport de division se présentant comme la somme du produit d'un premier facteur de division et de la partie fractionnaire et du produit d'un deuxième facteur de division et du complément à un de la partie fractionnaire, les moyens d'accumulation comprennent un registre d'accumulation produisant un premier opérande qui prend la valeur d'un signal d'addition en réponse au signal d'horloge et un circuit d'addition produisant ce signal d'addition comme la somme modulo le dénominateur de la partie fractionnaire du premier opérande et d'un deuxième opérande comprenant au moins le numérateur de la partie fractionnaire et produisant un signal de retenue, ledit absorbeur d'impulsions étant prévu pour absorber un nombre d'impulsions égal à la différence desdits deux facteurs de division en réponse au signal de retenue.

Par ailleurs, l'horloge à division de fréquence fractionnaire étant prévue pour être asservie sur un signal de synchronisation, elle comprend un module d'asservissement recevant ce signal de synchronisation et ledit signal d'horloge et produisant un signal de correction, le deuxième opérande étant la somme du numérateur et du signal de correction.

Ainsi, lorsque la fréquence dudit signal d'horloge est un multiple de celle du signal de synchronisation, le module d'asservissement comprend des moyens pour produire une valeur de comptage correspondant au nombre d'impulsions dudit signal d'hologe apparus durant une période de mesure de durée fixe, des moyens pour produire une valeur de correction proportionnelle à la différence d'une deuxième et d'une première valeur de comptage et inversement proportionnelle à la durée séparant le milieu de la deuxième et de la première périodes de mesure correspondantes, le signal de correction habituellement nul, étant affecté de la valeur de correction durant une période de correction exprimée comme un nombre de périodes du signal d'horloge.

De plus, dans l'horloge à division de fréquence fractionnaire la période de mesure étant un multiple de la période du signal de synchronisation, les première et deuxième périodes de mesure correspondantes étant consécutives, le module d'asservissement comprend un compteur recevant le signal d'horloge et produisant un signal de phase, la capacité de ce compteur étant un sous-multiple du rapport des fréquences des signaux d'horloge et de synchronisation, comprend un circuit de sommation produisant la deuxième valeur de comptage comme la somme des valeurs prises par le signal de phase au rythme du signal de synchronisation, un registre de temporisation produisant la première valeur de comptage comme la deuxième valeur de comptage avec un retard d'une période de mesure, un circuit de soustraction produisant un signal d'écart de phase comme la différence desdites deuxième et première valeurs de comptage, et un module de correction produisant la valeur de correction en proportion du signal d'écart de phase.

Avantageusement dans l'horloge à division de fréquence fractionnaire, une sortie élémentaire du compteur est utilisée pour produire un signal d'horloge auxiliaire.

Dans une variante de réalisation, l'horloge à division de fréquence fractionnaire comprend de plus un circuit de compensation produisant désormais la valeur de correction comme la somme des valeurs du signal de sortie du module de correction lors de la période de mesure précédente et de la période de mesure courante.

En plus, dans l'horloge à division de fréquence fractionnaire,le circuit de compensation comprend un additionneur à saturation limitant ladite valeur de correction à une valeur maximale déterminée.

Dans un mode de réalisation intéressant, l'horloge à division de fréquence fractionnaire comprend un circuit de limitation affectant le signal de correction de la valeur de correction pendant la première apparition d'un état déterminé d'une sortie élémentaire du compteur faisant suite au début d'une période du signal de synchronisation, le signal de correction étant nul pendant le reste de la période.

D'autre part, l'horloge à division de fréquence fractionnaire comprend un registre de synchronisation produisant comme signal de mesure le signal de phase en réponse à un signal de délcenchement issu d'un circuit de déclenchement dont la sortie prend la valeur dudit signal de synchronisation sur commande du signal d'horloge, le signal de mesure étant adressé au circuit de sommation.

Selon une caractéristique additionnelle, l'horloge à division de fréquence fractionnaire comprend un circuit de commande produisant un signal de commande dont la période vaut la période de mesure, ce signal de commande provoquant la remise à zéro du circuit de sommation, le transfert de l'entrée à la sortie du registre de temporisation et la modification du signal de sortie du circuit de compensation. Avantageusement, l'horloge à division de fréquence fractionnaire reçoit un signal d'initialisation prévu pour initialiser le circuit de compensation.

De plus, l'horloge à division de fréquence fractionnaire comprend un circuit d'initialisation imposant au compteur, une valeur de départ en réponse au signal d'initialisation.

Dans un cas particulier de l'horloge à division de fréquence fractionnaire la partie entière du rapport de division est nulle. Il est de plus possible de prévoir dans l'horloge à division de fréquence fractionnaire que la différence des deux facteurs de division soit égale à l'unité, l'absorbeur d'impulsions supprimant une seule impulsion sur commande.

Les différents objets et caractéristiques de la présente invention apparaîtront de manière plus précise dans le cadre de la description d'exemples de réalisation donnés à titre non limitatif en se référant aux figures annexées qui représentent :

- La figure 1, un schéma par blocs d'une horloge à division de fréquence fractionnaire selon l'invention,
- La figure 2, le schéma d'un module d'asservissement de cette horloge.

Les horloges à division de fréquence fractionnaire reçoivent un signal de rythme et produisent un signal d'horloge et sont prévues pour que les fréquences de ces signaux soient dans un rapport de division Q. Ce rapport peut toujours se décomposer comme la somme du produit d'un premier facteur de division A et d'une partie fractionnaire F et du produit d'un deuxième facteur de division B et du complément à un de cette partie fractionnaire, où les facteurs de division sont des nombres entiers et la partie fractionnaire un nombre compris entre zéro et un :

$$Q = A.F + B.(1-F)$$

Les différents nombres peuvent de plus être choisis tels que la différence des deux facteurs de division soit égale à l'unité :

$$A = B+1$$

De plus, la partie fractionnaire peut se représenter sous la forme d'une fraction comprenant un numérateur N et un dénominateur D :

$$F = N/D$$

L'invention décrite ci-après s'applique quelle que soit la valeur de ces différents nombres.

A titre d'exemple, afin de clarifier l'exposé, l'invention sera présentée en rapport avec un cas concret d'application concernant le système numérique cellulaire de radiocommunication. Dans ce cas un terminal mobile est pourvu d'un oscillateur interne qui produit le signal de rythme à une fréquence de 13 MHz. Il faut produire à partir de ce signal, le signal d'horloge utilisé notamment pour les circuits de traitement de la parole à une fréquence de 2,048 MHz. Le rapport de division vaut donc :

$$Q = 6,34765625$$
$$Q = 6 + 89/256$$
$$= 6 \left( \frac{256 - 89}{256} \right) + 7. \left( \frac{89}{256} \right)$$

En reprenant les notations précédentes :

$$A = 7 \quad B = 6 \quad F = \frac{89}{256}$$
$$N = 89 \quad D = 256$$

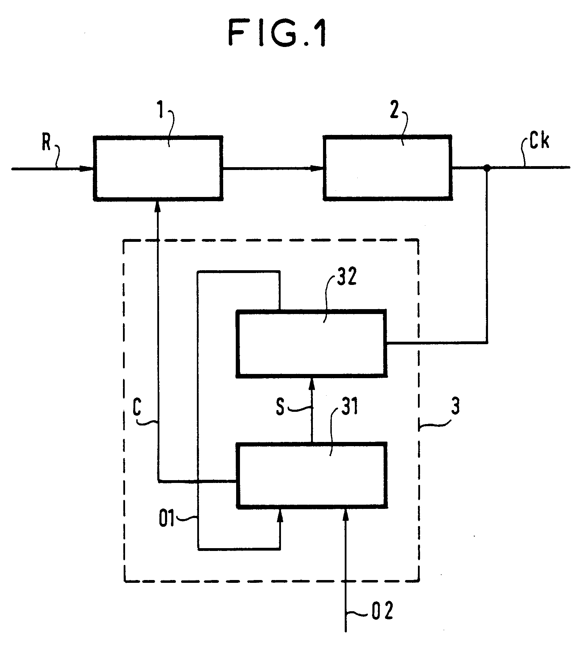

L'horloge à division de fréquence fractionnaire de l'invention représentée à la figure 1 comprend un absorbeur d'impulsions 1 qui reçoit le signal de rythme R et dont la sortie est reliée à l'entrée d'un circuit de division 2 qui produit le signal d'horloge Ck. Elle comprend également des moyens d'accumulation 3 recevant ce signal d'horloge et commandant l'absorbeur d'impulsions par un signal de retenue C, ces moyens étant prévus pour limiter le déphasage du signal d'horloge comme cela apparaîtra par la suite.

L'absorbeur d'impulsions 1 transmet directement sur sa sortie le signal de rythme R, sauf lorsqu'il reçoit le signal de retenue C. Dans ce dernier cas il supprime une impulsion du signal de rythme.

Le circuit de division 2 produit le signal d'horloge Ck dont la fréquence est un sous-multiple de celle du signal appliqué sur son entrée. Ce sous-multiple est égal au deuxième facteur de division B, 6 dans le cas présent. Ce circuit peut être un compteur, par exemple et, lorsqu'il divise par un nombre pair, ce sera avantageusement un compteur en anneau également connu sous le nom de compteur "Johnson". Un compteur de ce type est réalisé par la mise en série de bascules, la première d'entre elles recevant le signal de sortie de la dernière qui est le signal d'horloge Ck. Le sous-multiple est ici le double du nombre de bascules.

Les moyens d'accumulation 3 sont prévus pour déclencher l'absorbeur d'impulsions 1 à chaque fois que le produit de la partie fractionnaire F et d'un nombre d'impulsion du signal d'horloge compté à partir d'un instant d'origine change d'unité, c'est-à-dire lorsque sa partie entière s'accroît d'une unité. Cet instant d'origine est fixé arbitrairement, il constitue uniquement une référence de temps. Il peut être, par exemple, l'instant de mise en service de l'horloge.

Ces moyens d'accumulation 3 dans un mode de réalisation particulier qui ne doit pas être considéré comme une limitation de l'invention comprend un circuit d'addition 31 et un registre d'accumulation 32.

Le registre d'accumulation 32 produit un premier opérande $O_1$ qui a la valeur qu'avait un signal d'addition S lors de l'apparition de la dernière impulsion du signal d'horloge Ck.

Le circuit d'addition 32 produit ce signal d'addition S comme la somme du premier opérande et d'un deuxième opérande $O_2$ modulo le dénominateur D de la partie fractionnaire F. Le deuxième opérande, dans cette première partie de l'invention prend la valeur du numérateur N de cette partie fractionnaire F. Ce circuit est de plus prévu pour délivrer le signal de retenue C à destination de l'absorbeur d'impulsions 1, lorsque cette somme est supérieure au dénominateur.

Ainsi, chaque fois que le produit du numérateur et du nombre d'impulsions du signal d'horloge devient supérieur à un multiple du dénominateur auquel elle était inférieure auparavant, une impulsion du signal d'horloge est supprimée, ce qui revient à faire une division par le premier facteur de division A.

Dans l'exemple numérique considéré, le dénominateur est égal à 256. Le circuit d'addition peut donc consister en un simple additionneur délivrant un signal de sortie sur 8 bits et un signal de retenue.

L'invention s'applique si le rapport de division se réduit à la partie fractionnaire, c'est-à-dire si les premier A et deuxième B facteurs de division valent respectivment 1 et 0. Dans ce cas le circuit de division 2 se réduit à une simple liaison, le signal d'horloge Ck étant le signal de sortie de l'absorbeur d'impulsion 1.

Elle s'applique également si ces facteurs de division diffèrent de plus d'une unité. Il suffit alors de prévoir l'absorbeur d'impulsion 1 pour qu'il absorbe un nombre d'impulsions égal à la différence de ces deux facteurs. Cette opération qui est à la portée de l'homme de l'art ne sera pas plus détaillée.

Selon une caractéristique additionnelle de l'invention, l'horloge à division de fréquence fractionnaire est prévue pour être asservie par un module d'asservissement sur un signal de synchronisation dont la fréquence est un sous-multiple de celle du signal d'horloge.

Ce module d'asservissement est prévu pour enregistrer le nombre d'impulsions du signal d'horloge Ck durant une période de mesure de valeur fixée. Il produit une première valeur de comptage pendant une première période de mesure, puis une deuxième valeur de comptage durant une deuxième période de mesure. Il calcule ensuite une valeur de correction qui est proportionnelle à la différence de ces deux valeurs de comptage et inversement proportionnelle à la durée séparant les milieux des deux périodes de mesures correspondantes. Il produit enfin un signal de correction qui prend cette valeur de correction pendant une période de correction et qui est nul le reste du temps. Ce signal de correction est ajouté au numérateur N de la partie fractionnaire F pour former le deuxième opérande $O_2$ du circuit d'addition 31.

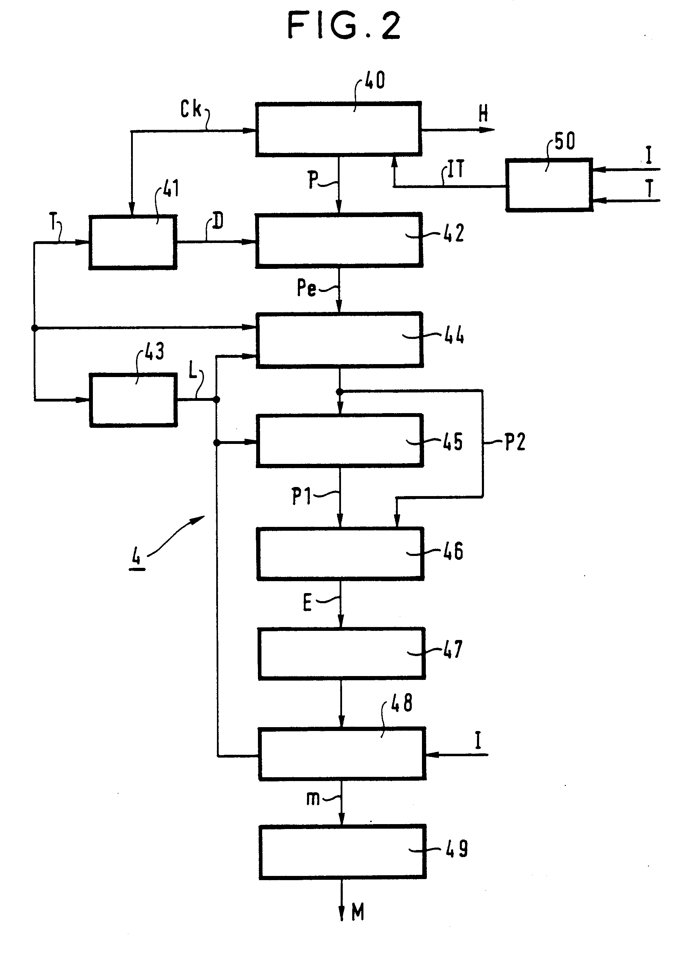

Ce module d'asservissement 4 apparaît dans un mode de réalisation donné uniquement à titre indicatif à la figure 2. Il comprend plusieurs organes qui seront maintenant détaillés.

Un compteur 40 reçoit le signal d'horloge Ck et produit un signal de phase P qui correspond au nombre d'impulsions apparues depuis sa remise à zéro. La capacité de ce compteur est un sous-multiple du rapport des fréquences du signal d'horloge Ck et du signal de synchronisation T.

Un circuit de déclenchement 41 produit un signal de déclenchement D qui prend la valeur qu'avait le signal de synchronisation T lors de l'apparition de la dernière impulsion du signal d'horloge Ck. Il peut s'agir, par exemple, d'une bascule connue sous le nom de bascule D.

Un registre de synchronisation 42 produit un signal de mesure Pe qui a la valeur qu'avait le signal de phase P lors de l'apparition de la dernière impulsion du signal de déclenchement D.

Un circuit de commande 43 produit un signal de commande L périodique dont la période vaut la période de mesure. Avantageusement, cette période de mesure sera un multiple de la période du signal de synchronisation.

Un circuit de sommation 44 délivre la deuxième valeur de comptage $P_2$ qui est la somme des valeurs prises par le signal de mesure Pe lors de chaque impulsion du signal de synchronisation T. Ce circuit est remis à zéro par le signal de commande L. Il apparaîtra plus clairement maintenant pourquoi le signal de sortie de ce circuit est la deuxième valeur de comptage.

Un registre de temporisation 45 produit la première valeur de comptage P1 comme la deuxième valeur de comptage retardée d'une période de mesure c'est-à-dire d'une période de signal de commande L. Ainsi se justifie la dénomination adoptée puisqu'a un instant donné, le signal de sortie de ce registre a la valeur qu'avait le signal de sortie du circuit de sommation 44 lors de la précédente période de mesure.

Un circuit de soustraction 46 produit un signal d'écart de phase E comme la différence des deux valeurs de comptage : $P_2 - P_1$.

Un module de correction 47 produit un signal de sortie dont la valeur est celle du signal d'écart de phase E divisée par le rapport entre la période de mesure et la période du signal de synchronisation T et multipliée par une constante que l'on dénomme couramment coefficient de raideur d'asservissement.

Un circuit de compensation 48 produit une valeur de correction m qui est la somme des valeurs du signal de sortie du module de correction 47 lors de la période de mesure précédente et lors de la période courante. Ce circuit est prévu pour limiter cette valeur de correction à une valeur maximale. Il comprendra par exemple un additionneur à saturation qui produit la somme des deux valeurs ou cette valeur maximale si cette somme lui est supérieure. Ce circuit est également prévu pour être initialisé au moyen d'un signal d'initialisation I.

Un circuit de limitation 49 produit le signal de correction M qui a la valeur de correction m pendant une période de correction et qui est nul le reste du temps. Cette période de correction pourra être d'une valeur quelconque et sera déterminée par l'homme du métier.

Ce signal de correction M est ajouté avec un additionneur non représenté dans la figure au numérateur N de la partie fractionnaire F pour donner le deuxième opérande O2.

Il est enfin prévu, à titre accessoire, que le compteur 40 soit initialisé à une valeur de départ $I_T$ au moyen d'un circuit d'initialisation 50 commandé par le signal d'initialisation I sur apparition du signal de synchronisation T.

Dans une variante de réalisation de l'horloge, le compteur 40 est de plus prévu pour délivrer un signal d'horloge auxiliaire H sur la sortie d'une de ces cellules de comptage. Ce signal d'horloge auxiliaire est en synchronisme avec le signal d'horloge et, tout comme celui-ci, il est asservi sur le signal de synchronisation T.

Cette variante trouve une application avantageuse dans le cas du terminal mobile précédemment mentionné. En effet certains composants destinés au traitement de la parole fonctionnent avec un signal à 2,048 MHz et un signal à 8 kHz qui est la fréquence d'échantillonage de la parole. De plus ces signaux doivent être asservis sur le signal de synchronisation à 50 Hz produit dans le terminal qui correspond au rythme des trames de communication.

Dans ce cas, la capacité du compteur 40 sera choisie égale à 256, le bit de poids fort correspondant au signal d'horloge auxiliaire H à une fréquence de 8 kHz.

Il apparaît que les valeurs de comptage $P_1$, $P_2$, dans ce cas, ne sont pas égales au nombre d'impulsions du signal d'horloge Ck produites durant les périodes de mesures correspondantes, car le compteur 40 aura accompli plusieurs cycles (160 dans ce cas) pendant une période du signal de synchronisation. Ces valeurs de comptage, par contre, correspondent à ces nombres d'impulsions puisqu'elles leurs sont congrues (modulo 256 dans ce cas). Etant donné le faible écart de fréquence qu'il y a entre le signal d'horloge lorsqu'il est asservi et lorsqu'il ne l'est pas, la capacité du compteur est suffisante. Si tel n'était pas le cas il est toujours possible d'augmenter la capacité de ce compteur afin d'élargir la plage de correction possible, sa capacité étant limitée au rapport des fréquences du signal d'horloge et du signal de synchronisation.

Une solution avantageuse consiste à réaliser le circuit de limitation 49 de manière que la période de correction soit la période du signal d'horloge auxiliaire H. Le signal de correction est affecté de la valeur de correction durant cette période et est nul pendant le reste de la période du signal de synchronisation T. Cette opération est répétée périodiquement au rythme du signal de synchronisation, par exemple.

Dans ce cas, si l'asservissement doit permettre d'obtenir un écart de fréquence relatif entre le signal d'hologe auxiliaire et le signal de synchronisation inférieur à 5 parties par million, la valeur de correction pourra prendre l'une des valeurs -2, -1, 0, 1 ou 2.

En effet, au cours d'une période du signal de synchronisation pour laquelle la valeur de correction est égale à 2, durant une période du signal d'horloge auxiliaire, le rapport de division vaut Qc = 6 + 91/256, tandis que durant les 159 autres périodes, il vaut Qo = 6 + 89/256. L'écart de fréquence vaut donc :

$$\frac{Qc - Qo}{160\ Qo} \approx 7,68 \cdot 10^{-6}$$

Le deuxième opérande $O_2$ qui est la somme de la valeur de correction et du numérateur sera donc un nombre entier compris entre 87 et 91. L'additionneur qui produit ce deuxième opérande peut se réduire à un simple circuit combinatoire qui produit les 4 bits de poids faible de cet opérande, ses 3 bits de poids fort étant invariables. En effet, les 5 valeurs décimales que peut prendre cet opérateur s'expriment comme suit en numérotation binaire :

87 = 101 0111
88 = 101 1000
89 = 101 1001
90 = 101 1010
91 = 101 1011

Par ailleurs, on remarquera que le signal de retenue C du circuit d'addition 33 est périodique. Sa période correspond à 256 impulsions du signal d'horloge Ck. Il s'ensuit que le signal d'horloge auxiliaire qui a la même période présente la particularité que toutes ses impulsions ont le même déphasage car elles sont séparées par le même nombre de périodes du signal de rythme R. Ainsi, lorsque le signal d'horloge auxiliaire est utilisé comme signal d'échantillonage, il n'introduit pas de modulation parasite sur le signal qui est échantilloné.

Un autre avantage de l'invention réside dans le fait que la répartition temporelle des divisions par le premier A et par le deuxième B facteur de division est la plus uniforme possible. Dans l'exemple numérique choisi (A = 7, B = 6), le déphasage maximum entre le signal d'horloge Ck et le signal de rythme également dénommé gigue de phase, vaut une période du signal de rythme soit 76,9 ns.

Le mode de réalisation du module d'asservissement 4 qui a été décrit présente une structure très complète qui procure les performances annoncées. L'invention s'applique également si certains organes sont supprimés.

En effet, le circuit de déclenchement 41 n'est pas strictement nécessaire, il permet uniquement de synchroniser le registre de synchronisation 42 sur le signal d'horloge Ck. On peut le supprimer en commandant directement ce registre avec le signal de synchronisation T au lieu du signal de déclenchement D.

Il n'est pas non plus indispensable de relever les valeurs de comptage $P_1$, $P_2$ sur plusieurs périodes du signal de synchronisation T, bien que cela améliore la précision de l'asservissement. Dans ce cas, le circuit de commande 43 est inutile, de même que le circuit de sommation 44. La deuxième valeur de comptage $P_2$ est égale au signal de mesure Pe qui est appliqué directement à l'entrée du registre de temporisation 45 à la place du signal de sortie du circuit de sommation 44. Ce registre de synchronisation est commandé par le signal de synchronisation T au lieu du signal de commande L, ce qui est également le cas pour le circuit de compensation 48.

De plus, ce circuit de compensation peut également être supprimé, la sortie du module de correction 47 étant directement reliée à l'entrée du circuit de limitation 49.

**Revendications**

1. Horloge à division de fréquence fractionnaire comprenant un circuit de division (2) qui produit un signal d'horloge (Ck) à partir d'un signal de rythme (R), les fréquences de ces deux signaux étant dans un rapport de division (Q) qui est la somme d'une partie entière et d'une partie fractionnaire (F), comprenant également un absorbeur d'impulsions (1) recevant ledit signal de rythme et le transmettant audit circuit de division (2) en supprimant une impulsion au moins de ce signal sur commande, caractérisé en ce qu'il comprend des moyens d'accumulation (3) pour commander ledit absorbeur d'impulsions (1) à chaque fois que le produit du nombre d'impulsions dudit signal d'horloge (Ck) comptées à partir d'un instant d'origine et de ladite partie fractionnaire change d'unité.

2. Horloge à division de fréquence fractionnaire selon la revendication 1 caractérisée en ce que, ledit rapport de division (Q) se présentant comme la somme du produit d'un premier facteur de division (A) et de ladite partie fractionnaire (F) et du produit d'un deuxième facteur de division (B) et du complément à une de ladite partie fractionnaire, lesdits moyens d'accumulation (3) comprennent un registre d'accumulation (32) produisant un premier opérande (O1) qui prend la valeur d'un signal d'addition (S) en réponse audit signal d'horloge (Ck) et un circuit d'addition (33) produisant ledit signal d'addition comme la somme modulo le dénominateur (D) de ladite partie fractionnaire dudit premier opérande (O1) et d'un

deuxième opérande (O2) comprenant au moins le numérateur (N) de ladite partie fractionnaire (F) et produisant un signal de retenue (C), ledit absorbeur d'impulsions (1) étant prévu pour absorber un nombre d'impulsions égal à la différence desdits deux facteurs de division en réponse audit signal de retenue (C).

3. Horloge à division de fréquence fractionnaire selon la revendication 2, caractérisée en ce que, étant prévue pour être asservie sur un signal de synchronisation (T), elle comprend un module d'asservissement (4) recevant ce signal de synchronisation et ledit signal d'horloge (Ck) et produisant un signal de correction (M), ledit deuxième opérande (O2) étant la somme dudit numérateur (N) et dudit signal de correction.

4. Horloge à division de fréquence fractionnaire selon la revendication 3, caractérisée en ce que, la fréquence dudit signal d'horloge (Ck) étant un multiple de celle dudit signal de synchronisation (T), ledit module d'asservissement (4) comprend des moyens pour produire une valeur de comptage correspondant au nombre d'impulsions dudit signal d'hologe (Ck) apparus durant une période de mesure de durée fixe, des moyens pour produire une valeur de correction (m) proportionnelle à la différence d'une deuxième ($P_2$) et d'une première ($P_1$) valeur de comptage et inversement proportionnelle à la durée séparant le milieu de la deuxième et de la première périodes de mesure correspondantes, ledit signal de correction (M) habituellement nul, étant affecté de ladite valeur de correction (m) durant une période de correction exprimée comme un nombre de périodes dudit signal d'horloge (Ck).

5. Horloge à division de fréquence fractionnaire selon la revendication 4, caractérisée en ce que ladite période de mesure étant un multiple de la période dudit signal de synchronisation (T), lesdites première et deuxième périodes de mesure correspondantes étant consécutives, ledit module d'asservissement (4) comprend un compteur (40) recevant ledit signal d'horloge (Ck) et produisant un signal de phase (P), la capacité de ce compteur étant un sous-multiple du rapport des fréquences desdits signaux d'horloge (Ck) et de synchronisation (T), comprend un circuit de sommation (44) produisant ladite deuxième valeur de comptage ($P_2$) comme la somme des valeurs prises par ledit signal de phase (P) au rythme dudit signal de synchronisation (T), un registre de temporisation (45) produisant ladite première valeur de

comptage ($P_1$) comme ladite deuxième valeur de comptage avec un retard d'une dite période de mesure, un circuit de soustraction (46) produisant un signal d'écart de phase (E) comme la différence desdites deuxième et première valeurs de comptage, et un module de correction (47) produisant ladite valeur de correction (m) en proportion dudit signal d'écart de phase (Pe).

6.  Horloge à division de fréquence fractionnaire selon la revendication 5, caractérisée en ce qu'une sortie élémentaire dudit compteur (40) est utilisée pour produire un signal d'horloge auxiliaire (H).

7.  Horloge à division de fréquence fractionnaire selon la revendication 5 ou 6, caractérisée en ce qu'elle comprend de plus un circuit de compensation (48) produisant désormais ladite valeur de correction (m) comme la somme des valeurs du signal de sortie dudit module de correction (47) lors de la période de mesure précédente et de la période de mesure courante.

8.  Horloge à division de fréquence fractionnaire selon la revendication 7, caractérisée en ce que ledit circuit de compensation (48) comprend un additionneur à saturation limitant ladite valeur de correction (m) à une valeur maximale déterminée.

9.  Horloge à division de fréquence fractionnaire selon l'une quelconque des revendications 5 à 8, caractérisée en ce qu'elle comprend un circuit de limitation (41) affectant ledit signal de correction (M) de ladite valeur de correction (m) pendant la première apparition d'un état déterminé d'une sortie élémentaire dudit compteur (40) faisant suite au début d'une période dudit signal de synchronisation (T), ledit signal de correction étant nul pendant le reste de ladite période.

10. Horloge à division de fréquence fractionnaire selon l'une quelconque des revendications 5 à 9, caractérisée en ce qu'elle comprend un registre de synchronisation (42) produisant comme signal de mesure (Pe) ledit signal de phase (P) en réponse à un signal de délcenchement (D) issu d'un circuit de déclenchement (41) dont la sortie prend la valeur dudit signal de synchronisation (T) sur commande dudit signal d'horloge (Ck), ledit signal de mesure étant adressé audit circuit de sommation (44).

11. Horloge à division de fréquence fractionnaire selon la revendication 10, caractérisée en ce qu'elle comprend un circuit de commande (43) produisant un signal de commande (L) dont la période vaut ladite période de mesure, ce signal de commande provoquant la remise à zéro dudit circuit de sommation (44), le transfert de l'entrée à la sortie dudit registre de temporisation (45) et la modification du signal de sortie dudit circuit de compensation (48).

12. Horloge à division de fréquence fractionnaire selon l'une quelconque des revendications 5 à 11, caractérisée en ce qu'elle reçoit un signal d'initialisation (I) prévu pour initialiser ledit circuit de compensation (48).

13. Horloge à division de fréquence fractionnaire selon la revendication 12, caractérisée en ce qu'elle comprend un circuit d'initialisation (50) imposant audit compteur (40) une valeur de départ en réponse audit signal d'initialisation (I).

14. Horloge à division de fréquence fractionnaire selon l'une quelconque des revendications 1 à 13, caractérisée en ce que la partie entière dudit rapport de division (Q) est nulle.

15. Horloge à division de fréquence fractionnaire selon l'une quelconque des revendications 2 à 13, caractérisée en ce que la différence des deux facteurs de division (A, B) est égale à l'unité, ledit absorbeur d'impulsions (1) supprimant une seule impulsion sur commande.

# FIG.1

# FIG.2

**Office européen
des brevets**

# RAPPORT DE RECHERCHE EUROPEENNE

Numéro de la demande

**EP 91 11 3849**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,X | EP-A-0 019 412   (THE MARCONI CO., LTD) <br> – – – | 1-2,14-15 | H 03 K 23/66 |
| D,A | EP-A-0 019 412   (* page 5, ligne 15 - page 16, ligne 22; figures 1-5 *) <br> – – – – – | 2-13 | |

**DOMAINES TECHNIQUES RECHERCHES (Int. Cl.5)**

H 03 K
H 03 L

Le présent rapport de recherche a été établi pour toutes les revendications

| Lieu de la recherche | Date d'achèvement de la recherche | Examinateur |
|---|---|---|
| La Haye | 25 novembre 91 | SEGAERT P.A.O.M.P. |

CATEGORIE DES DOCUMENTS CITES
X : particulièrement pertinent à lui seul
Y : particulièrement pertinent en combinaison avec un
    autre document de la même catégorie
A : arrière-plan technologique
O : divulgation non-écrite
P : document intercalaire
T : théorie ou principe à la base de l'invention

E : document de brevet antérieur, mais publié à la
    date de dépôt ou après cette date
D : cité dans la demande
L : cité pour d'autres raisons
---------------------------------------------------------------
& : membre de la même famille, document
    correspondant